# EUROPEAN PATENT APPLICATION

(11) **EP 3 007 272 A1**
(43) Date of publication of application: **13.04.2016**
(21) Application number: 14803913.4
(22) Date of filing: 28.05.2014
(51) Int. Cl.: H01Q 1/52, H01Q 15/14, H05K 1/02

(54) **EBG STRUCTURE**

(30) Priority: 30.05.2013 JP 2013114226
(71) Applicant: Nitto Denko Corporation, Ibaraki-shi, Osaka 567-8680 (JP)
(72) Inventor: UEDA, Tetsuya, Kyoto-shi Kyoto 606-8585 (JP); HATANAKA, Takezo, Kyoto-shi Kyoto 606-8585 (JP)
(74) Representative: Müller-Boré & Partner Patentanwälte PartG mbB
(86) International application number: PCT/JP2014/064060
(87) International publication number: WO 2014/192784

(57) **Abstract**

An EBG structure of the present invention includes a ground substrate, a first dielectric layer disposed on the ground substrate, a first conductor pattern disposed on the first dielectric layer, and has an outer end and an inner end, the outer end being electrically connected to the ground substrate, a second dielectric layer disposed on the first conductor pattern, and a second conductor pattern disposed on the second dielectric layer, and has a center part and an outer end, the center part being electrically connected to the inner end of the first conductor pattern.

## Description

### CROSS-REFERENCE TO RELATED APPLICATION

This application claims priority to Japanese Patent Application No. 2013-114226 filed on May 30, 2013, the disclosure of which is incorporated herein by reference in its entirety.

### FIELD OF THE INVENTION

The present invention relates to an EBG (Electromagnetic Band Gap) structure.

### BACKGROUND ART

As a perfect conductor, there are a PEC (Perfect Electric Conductor) and a PMC (Perfect Magnetic Conductor). The PEC causes reversal of the phase of reflected waves and hence a great return loss (for example, when the PEC is used as a grounding face for an antenna, the received power is lowered due to the difference between the radio frequency and the frequency of a receiving circuit). The PMC causes small phase change due to the reflection and small return loss, but does not exist in nature. The EBG structure is defined as "artificial medium for controlling the propagation of electromagnetic waves for all angles of incidence and polarization characteristics in a specific frequency band", it behaves like a PMC in a particular frequency band. That is, the EBG structure is used for such as a grounding face for a low profile antenna since it suppresses or prevents the propagation of electromagnetic waves in a specific frequency band.

A representative example of the EBG structure is an EBG structure of a mushroom type that was proposed by Mr. Sievenpiper who was a student in a doctor's course at the UCLA (Patent Literature 1). This structure includes plural top electrodes (metal patches of a square shape) two-dimensionally arranged at certain intervals, in which these top electrodes are connected to a ground substrate by vias (shorting pins). An inductor is formed in a path extending from the top electrode through the via, the ground substrate and the adjacent via to the adjacent top electrode. A capacitor is formed in a gap between each adjacent top electrodes. The inductor and the capacitor form an LC parallel resonance circuit. That is, unit cells each composed of an inductance component L and a capacitance component C are arranged adjacent to each other to thereby form LC parallel resonance circuits. Plural top electrodes are two-dimensionally arranged so that the LC parallel resonance circuits are also two-dimensionally arranged. The array structure of the LC parallel resonance circuits has high impedance characteristics at a resonant frequency, and the band gap is formed in the EBG structure.

The mushroom-type EBG structure was then subjected to various improvements. One of such improvements is described in Patent Literature 2. According to the structure described in this literature, external environmental conditions such as a temperature are changed so as to change the length of a via and hence change the inductance component L, or to change the area of the ground substrate and hence change the capacitor component C. With this structure, it is said that the frequency band to form a band gap can be changed.

### PRIOR ART LETERATURE

### Patent Literature

PATENT LITERATURE 1 JP-2002-510886 T
PATENT LITERATURE 2 JP-2008-147763 A

### SUMMARY OF THE INVENTION

### PROBLEMS TO BE SOLVED BY THE INVENTION

However, any of not only the mushroom-type EBG structure but also other conventional EBG structures has band gap characteristics at a frequency band in GHz level. An EBG structure which attained significant reduction in frequency (specifically, a frequency range in MHz level or further a frequency range in KHz level) does not exist hitherto.

### MEANS TO SOLVE

An EBG structure according to the present invention is designed to attain significant reduction in operating frequency, and includes a ground substrate, a dielectric layer that is disposed on the ground substrate, and a conductor pattern that is disposed on the dielectric layer, and has one end and another end, the one end being electrically connected to the ground substrate.

According to the present invention, there is provided an EBG structure including: a ground substrate; a first dielectric layer that is disposed on the ground substrate; a first conductor pattern that is disposed on the first dielectric layer, and has an outer end and an inner end, the outer end being electrically connected to the ground substrate; a second dielectric layer that is disposed on the first conductor pattern; and a second conductor pattern that is disposed on the second dielectric layer, and has a center part and an outer end, the center part being electrically connected to the inner end of the first conductor pattern.

As one form of the EBG structure according to the present invention, the first conductor pattern may have a spiral shape.

As another form of the EBG structure according to the present invention, it may be configured such that the second conductor pattern has a linear part that extends radially from the center part, and a side part that crosses an end of the linear part and forms the outer end of the second conductor pattern.

In this case, the side part may be respectively disposed along the outer periphery of the first conductor pattern and may be disposed outside the first conductor pattern.

As another form of the EBG structure according to the present invention, it may be configured such that a plurality of first conductor patterns are disposed in matrix like manner, and a plurality of second conductor patterns are disposed in matrix like manner so as to have the side parts of each adjacent second conductor patterns of the plurality of second conductor patterns facing each other.

### BRIEF DESCRIPTION OF THE DRAWINGS

Fig. 1 is a plan view of an EBG structure according to one embodiment of the present invention.
Fig. 2 is a plan view of one cell of the EBG structure.
Fig. 3 is an exploded perspective view of one cell of the EBG structure.
Fig. 4A is a cross sectional view taken along a line A-A in Fig. 2.
Fig. 4B is a cross sectional view taken along a line B-B in Fig. 2.
Fig. 5A is a band gap characteristic view of the EBG structure.
Fig. 5B is a band gap characteristic view showing the case where a top electrode is provided and the case where a top electrode is not provided.
Fig. 6 is a plan view of an EBG structure according to another embodiment of the present invention.
Fig. 7 is a plan view of an EBG structure according to still another embodiment of the present invention.
Fig. 8 is a plan view of an EBG structure according to yet another embodiment of the present invention.

### DETAILED DESCRIPTION OF THE PREFERRED EMBODIMENT

An EBG structure according to the present embodiment is designed to attain significant reduction in operating frequency, and includes: a ground substrate; a dielectric layer that is disposed on the ground substrate; and a conductor pattern that is disposed on the dielectric layer, and has one end and another end, the one end being electrically connected to the ground substrate.

According to the above configuration, in an arrangement with at least two unit cells of the conductor pattern aligned side by side, an inductor is formed in a path from the other end of the conductor pattern to the other end of the adjacent conductor pattern, passing through the one end of the conductor pattern, the ground substrate and the one end of the adjacent conductor pattern. In this case, a capacitor is formed in a gap between the adjacent conductor patterns. The inductor and the capacitor form an LC parallel resonance circuit. Alternatively, when one unit cell of the conductor pattern is disposed, an inductor is formed in a path from the other end of the conductor pattern to the ground substrate passing through the one end of the conductor pattern. In this case, a capacitor is formed in a gap between the other end of the conductor pattern and the ground substrate. The inductor and the capacitor form an LC parallel resonance circuit.

The path forming the inductance has a component parallel to a principal surface of the ground substrate, as well as a component orthogonal to a principal surface of the ground substrate, by the conductor pattern. Because of this, the EBG structure has a longer path and hence a significantly large inductance component L. Whereby, it is possible to attain significant reduction in operating frequency.

The EBG structure according to the present embodiment includes: a ground substrate; a first dielectric layer that is disposed on the ground substrate; a first conductor pattern that is disposed on the first dielectric layer, and has an outer end and an inner end, the outer end being electrically connected to the ground substrate; a second dielectric layer that is disposed on the first conductor pattern; and a second conductor pattern that is disposed on the second dielectric layer, and has a center part and an outer end, the center part being electrically connected to the inner end of the first conductor pattern.

According to the above configuration, in an arrangement with at least two unit cells of the first conductor pattern and the second conductor pattern aligned side by side, an inductor is formed in a path from the outer end of the second conductor pattern to the outer end of the adjacent second conductor pattern, passing through the center part of the second conductor pattern, the inner end and then the outer end of the first conductor pattern, the ground substrate, and the outer end of the first conductor pattern. In this case, a capacitor is formed in a gap between the outer ends of each adjacent second conductor patterns. The inductor and the capacitor form an LC parallel resonance circuit. Alternatively, in an arrangement with one unit cell of the first and second conductor patterns disposed, an inductor is formed in a path from the outer end of the second conductor pattern to the ground substrate, passing through the center part of the second conductor pattern, and the inner end and then the outer end of the first conductor pattern. In this case, a capacitor is formed in a gap between the outer end of the second conductor pattern and the ground substrate. The inductor and the capacitor form an LC parallel resonance circuit.

The path forming the inductance has a component parallel to a principal surface of the ground substrate, as well as a component orthogonal to a principal surface of the ground substrate, by the first conductor pattern. Because of this, the EBG structure has a longer path and hence a significantly large inductance component L. Whereby, it is possible to attain significant reduction in operating frequency.

As one form of the EBG structure according to the present embodiment, the first conductor pattern may have a spiral shape.

With the above configuration, it is possible to efficiently increase the inductance component L in a limited space of the unit cell.

As another form of the EBG structure according to the present embodiment, the second conductor pattern may have a linear part that extends radially from the center part, and a side part that crosses an end of the linear part and forms the outer end of the second conductor pattern.

According to the above configuration, in an arrangement with at least two unit cells of the first and second conductor patterns aligned side by side, and the unit cells are disposed in matrix like manner so as to have the side parts of each adjacent second conductor patterns facing each other, the outer end of the second conductor pattern, which forms the capacitor, has a large width due to the side part. Accordingly, the capacitor component C is increased. Further, a portion of the second conductor pattern, which overlaps in area with the first conductor pattern is the linear part having a smaller width. Therefore, the magnitude of a magnetic field formed by the first conductor pattern 5 is prevented from being decreased due to the second conductor pattern 7. With these configurations, it is possible to attain significant reduction in operating frequency.

In this case, the side part may be disposed along the outer periphery of the first conductor pattern and disposed outside the first conductor pattern.

According to the above configuration, influences of the side part to the magnetic field formed by the first conductor pattern is eliminated or decreased, and therefore it is possible to attain further reduction in operating frequency.

As another form of the EBG structure according to the present embodiment, it may be configured such that a plurality of first conductor patterns are disposed in matrix like manner, and a plurality of second conductor patterns are disposed in matrix like manner so as to have the side parts of each adjacent second conductor patterns of the plurality of second conductor patterns facing each other.

According to the above configuration, it is possible to produce various operational effects as mentioned above for the case where at least two unit cells of the first and second conductor patterns are aligned side by side.

As described above, according to the present embodiment, the conductor pattern is formed in the path, and the length of the path is significantly increased, so that the inductance component L can be significantly increased. Whereby, it is possible to attain significant reduction in operating frequency.

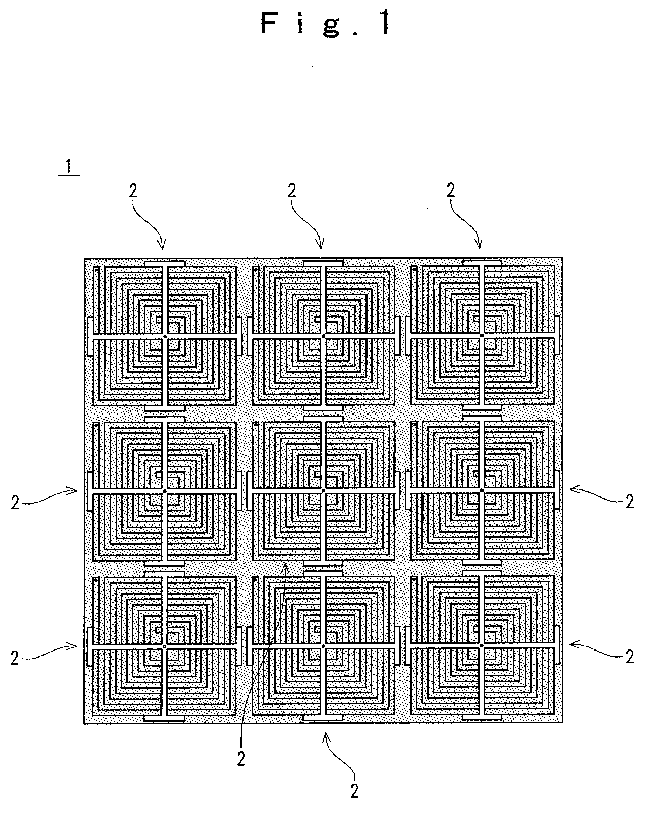

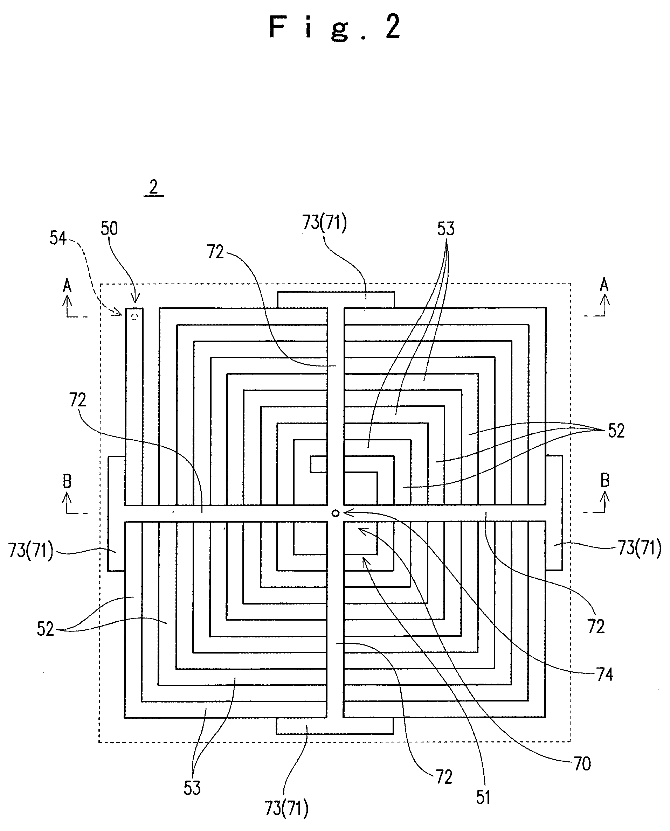

Now, the description is given for one embodiment of the EBG structure according to the present invention with reference to the attached drawings. Fig. 1 is a plan view of an EBG structure 1. As shown in Fig. 2, the EBG structure 1 includes the unit cells 2 that are disposed in matrix like manner with 3 rows by 3 columns. It is to be noted that the matrix like manner with 3 rows by 3 columns is merely an example, and therefore it is a matter of course that the number of the unit cell 2, including one unit cell, is appropriately selected within a range required to form the EBG structure.

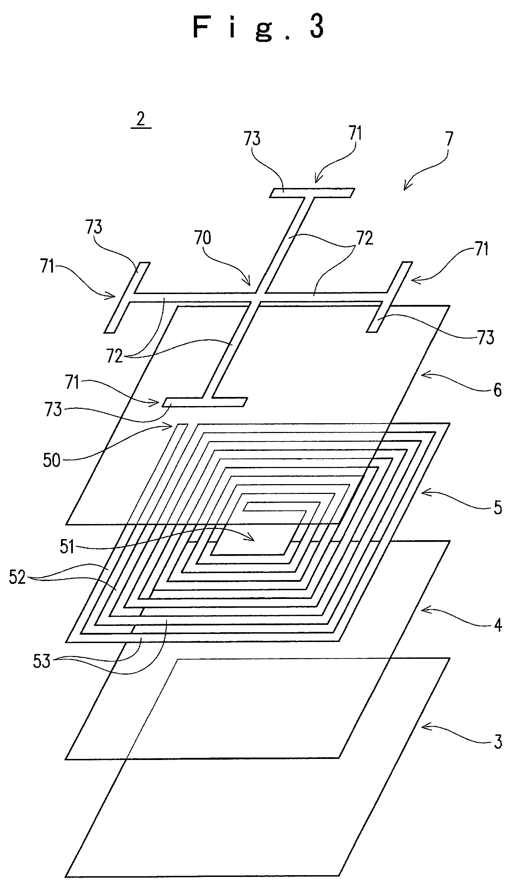

As shown in Fig. 2 and Fig. 3, the EBG structure 1 includes unit cells 2, each having a laminate structure which is composed of a ground substrate 3, a first dielectric layer 4 that is disposed on the ground substrate 3, a first conductor pattern 5 that is dispose on the first dielectric layer 4, and has an outer end 50 and an inner end 51, in which the outer end 50 is electrically connected to the ground substrate 3, a second dielectric layer 6 that is disposed on the first conductor pattern 5, and a second conductor pattern 7 that is disposed on the second dielectric layer 6, and has a center part 70 and outer ends 71, in which the center part 70 is electrically connected to the inner end 51 of the first conductor pattern 5.

The ground substrate 3 is a conductor such as a metal plate. The ground substrate 3 is electrically connected to a ground substrate 3 of another unit cell 2. The ground substrate 3 is preferably integrated with a ground substrate 3 of another unit cell 2. In the present embodiment, the ground substrate 3 is a metal plate formed with a size of the EBG structure 1.

The first dielectric layer 4 is an insulating body such as a resin plate, and is disposed on the ground substrate 3 to cover over a principal surface of the ground substrate 3. The first dielectric layer 4 is integrated with a first dielectric layer 4 of another unit cell 2. In the present embodiment, the first dielectric layer 4 is a resin plate formed with a size of the EBG structure 1, that is, a resin plate having the same size as that of the ground substrate 3.

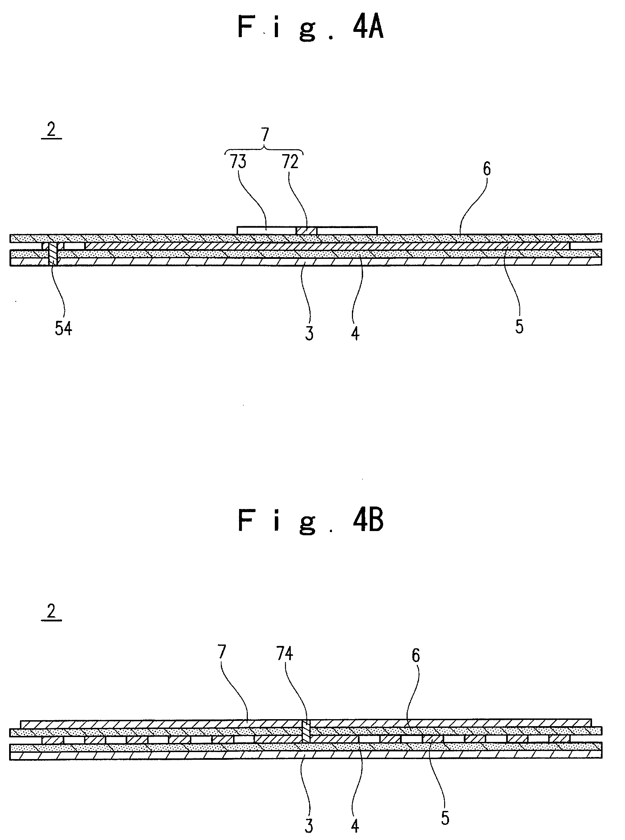

The first conductor pattern 5 is a conductor such as a metal elongated strip extending from the outer end 50 to the inner end 51. The first conductor pattern 5 has a spiral shape, and more specifically a rectangular spiral shape having vertical strips 52 and lateral strips 53 that are alternately aligned with each other. As shown in Fig. 2 and Fig. 4A, a conductor pin 54 connected to the outer end 50 extends through the first dielectric layer 4 and then is connected to the ground substrate 3 to be electrically connected to the ground substrate 3. More specifically, the outer end 50 of the first conductor pattern 5 is electrically connected to the ground substrate 3 with one end part of the conductor pin 54 fitted in a hole formed in the outer end 50 of the first conductor pattern 5, and another end part of the conductor pin 54 fitted in a hole formed in the ground substrate 3.

As shown in Fig. 2 and Fig. 3, the second dielectric layer 6 is an insulating body such as a resin plate, and is disposed over the first conductor pattern 5. The second dielectric layer 6 is integrated with a second dielectric layer 6 of another unit cell 2. In the present embodiment, the second dielectric layer 6 is a resin plate having the same size as that of the EBG structure 1 or that of the ground substrate 3 or the first dielectric layer 4.

The second conductor pattern 7 is a conductor such as a metal elongated strip extending from the center part 70 to the outer ends 71. The second conductor pattern 7 has a radially extending shape, and more specifically a cross shape having four linear parts 72 extending radially from the center part 70 at an equal angle (90 degrees intervals). The linear parts 72 are respectively provided at their ends with side parts 73 that cross the corresponding linear parts 72 and form the outer ends 71 of the second conductor pattern 7. The side parts 73 cross the respective ends of the linear parts 72 at center points of the side parts 73. In this embodiment, the side parts 73 orthogonally cross the linear parts 72.

As shown in Fig. 2 and Fig. 4B, the center part 70 of the second conductor pattern 7 is electrically connected to the first conductor pattern 5 by a conductor pin 74 connected to the center part 70, the conductor pin 74 extending through the second dielectric layer 6 and being connected to the inner end 51 of the first conductor pattern 5. More specifically, the center part 70 of the second conductor pattern 7 is electrically connected to the inner end 51 of the first conductor pattern 5 by one end part of the conductor pin 74 fitted in a hole formed in the center part 70 of the second conductor pattern 7, and another end part of the conductor pin 74 fitted in a hole formed in the inner end 51 of the first conductor pattern 5.

With the above configuration, the side parts 73 of the second conductor pattern 7 are respectively disposed along the outer periphery of the first conductor pattern 5. More specifically, the side parts 73 of the second conductor pattern 7 are respectively disposed along a pair of outermost vertical strips 52 and a pair of outermost lateral strips 53 of the first conductor pattern 5. The side parts 73 respectively do not overlap with the corresponding outermost vertical strips 52 and the outermost lateral strips 53 so as to be disposed outside thereof. The side parts 73 are shorter in length than the corresponding outermost vertical strips 52 and the corresponding outermost lateral strips 53.

The thus configured unit cell 2 has a square shape in plan view, and 9 unit cells 3 are disposed in matrix like manner with 3 rows by 3 columns to form the EBG structure 1. An inductor is formed in a path extending from the side parts 73 of the second conductor pattern 7 to corresponding side parts 73 of an adjacent second conductor pattern 7, passing through the linear parts 72, then the center part 70, and then the conductor pin 74 of the second conductor pattern 7, the inner end 51 and then the outer end 50 of the first conductor pattern 5 and the conductor pin 54 of the first conductor pattern 5, the ground substrate 3, and an adjacent conductor pin 54. A capacitor is formed in a gap between the side parts 73 of the adjacent second conductor patterns 7. The inductor and the capacitor form an LC parallel resonance circuit. That is, the LC parallel resonance circuit is formed by unit cells disposed adjacent to each other and each composed of an inductance component L and a capacitance component C. A plurality of the second conductor patterns 7 are two-dimensionally arranged so that the LC parallel resonance circuits are also two-dimensionally arranged. The array structure of the LC parallel resonance circuits has high impedance characteristics at a resonant frequency, and the band gap is formed in the EBG structure.

The path forming the inductance has a component parallel to a principal surface of the ground substrate 3, as well as a component orthogonal to a principal surface of the ground substrate 3. Because of this, the EBG structure 1 of the present embodiment has a much longer path and a much larger inductance component L than the conventional mushroom-type EBG structure. The outer ends 71 of the second conductor pattern 7, which form the capacitor, each have a greater width than the residual part (due to the presence of the side part 73). Portions of the second conductor pattern 7, which overlap in area with the first conductor pattern 5 are the linear parts 72 having smaller width. Therefore, the magnitude of a magnetic field formed by the first conductor pattern 5 is prevented from being decreased due to the second conductor pattern 7. With these configurations, according to the EBG structure 1 of the present embodiment, it is possible to attain significant reduction in operating frequency.

### EXAMPLES

An inspection was made to confirm the effect of the EBG structure 1 according to the present embodiment. The size of the unit cell 2 was 30 mm by 30 mm. Three EBG structures 1 respectively having three arrays, namely a 1-by-1 cell array, a 3-by-3 cell array, and a 5-by-by cell array were used. A loop antenna having a diameter of 28 mm was disposed on each of them and the gain was measured.

A method for fabricating the EBG structure 1 having a 1-by-1 cell array is described as follows. Two laminate materials are prepared, each having a resin substrate having a thickness of 0.8 mm and a copper film having a thickness of 18 µm disposed on each of both sides of the rein substrate. The copper film on the other side of one laminate material is subjected to a conventional processing such as etching or cutting to form a first conductor 4n 5. Subsequent to or prior to forming the first conductor pattern 5, the conductor pin 54 is pressed into the laminate material. Then, the copper film on the one side of the other laminate material is removed, and the other laminate material is disposed on the one laminate material so as to have the exposed resin substrate covering the copper film on the other side of the one laminate material or covering the first conductor pattern 5. Then, the conductor pin 74 is pressed therein. Subsequent thereto, or at the same time as or prior to removing the copper film on the one side of the other laminate material, the copper film on the other side of the other laminate material is subjected to a conventional processing such as etching or cutting. Whereby, the second conductor pattern 7 is formed. That is, of the one laminate material, the copper film on the one side turns to be the ground substrate 3, the resin substrate to the first dielectric layer 4, and the processed copper film on the other side to the first conductor pattern 5, respectively. Of the other laminate material, the resin substrate turns to be the second dielectric layer 6, and the processed copper film on the other side to the second conductor pattern 7, respectively.

For the 3-by-3 cell array, laminate materials each having a size of 90 mm by 90 mm are used. A copper film on the other side of one laminate material is processed to form 9 pieces of the first conductor pattern 5. Along with this, a copper film on the other side of the other laminate material is processed to form 9 pieces of the second conductor pattern 7. The method for fabrication is the same as that for the 1-by-1 cell array, except for this.

For the 5-by-by cell array, laminate materials each having a size of 150 mm by 150 mm are used. A copper film on the other side of one laminate material is processed to form 25 pieces of the first conductor pattern 5. Along with this, a copper film on the other side of the other laminate material is processed to form 25 pieces of the second conductor pattern 7. The method for fabrication is the same as that for the 1-by-1 cell array, except for this.

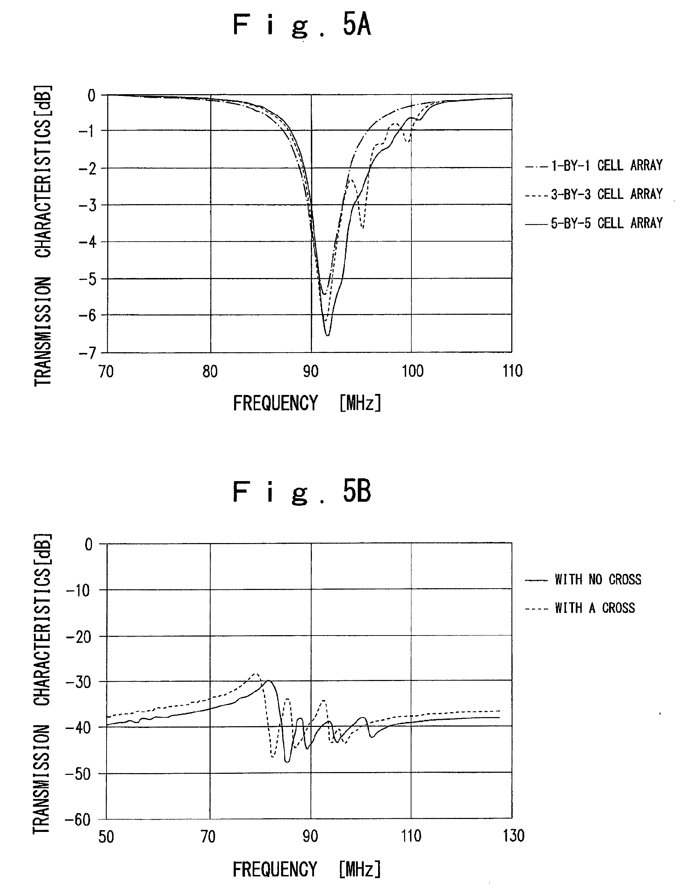

Fig. 5A is a graph showing resonant frequencies (operating frequencies) respectively for the three EBG structures 1 of the 1-by-1 cell array, the 3-by-3 cell array, and the 5-by-by cell array. The horizontal axis represents "Frequency [MHz]", and the vertical axis represents "S11 Magnitude [dB]". For any structure, the operating frequency is observed around 91 MHz, and it can be seen from this that the band gap characteristics exist at a frequency band in MHz level. This is due to the inductance component L by the first conductor pattern 5 and the capacitor component C by the side parts 73 of the second conductor pattern 7, as described above.

The EBG structure of the present embodiment having the above configuration is not necessarily limited thereto and may be appropriately changed within the intended scope of the present invention. The advantageous effects of the present invention are also not necessarily limited to the above embodiment. That is, the embodiments disclosed herein are to be considered in all respects as illustrative and not restrictive. The scope of the present invention is indicated by the appended claims rather than by the foregoing description. All changes which come within the meaning and range of equivalency of the claims are therefore intended to be embraced therein. For example, in the above embodiments, the unit cell 2 is provided with the first conductor pattern 5 and the second conductor pattern 7. However, the present invention is not necessarily limited thereto. As can be seen from the graph of Fig. 5B (the horizontal axis represents "Frequency [MHz]", and the vertical axis represents "S21 Magnitude [dB]"), it can be confirmed that the band gap characteristics exist at a frequency band in MHz level even without the second conductor pattern 7, and therefore the present invention encompasses an EBG structure having no second conductor pattern 7. However, as can be seen from the graph of Fig. 5B, the EBG structure having the second conductor pattern 7 has more improved gain and therefore the EBG structure having the second conductor pattern 7 is preferable.

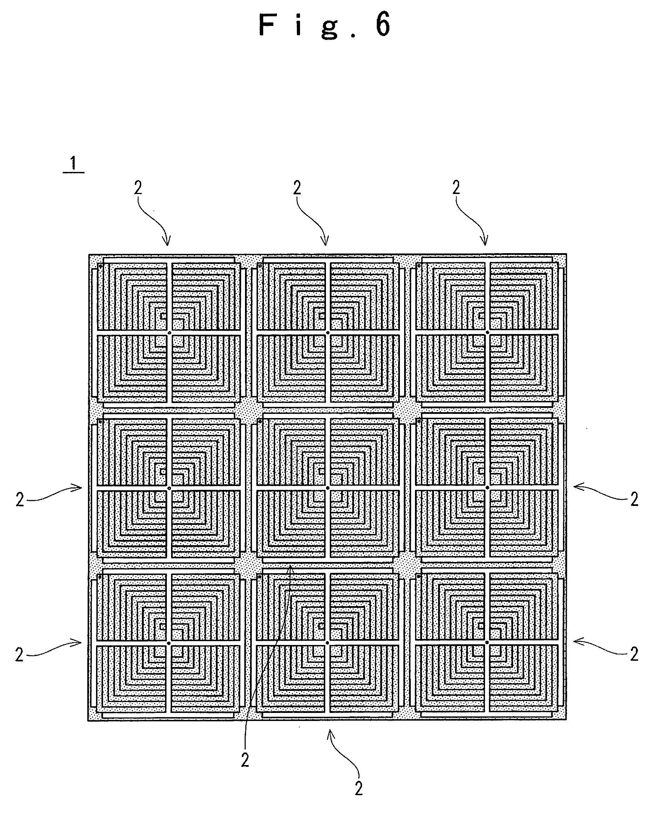

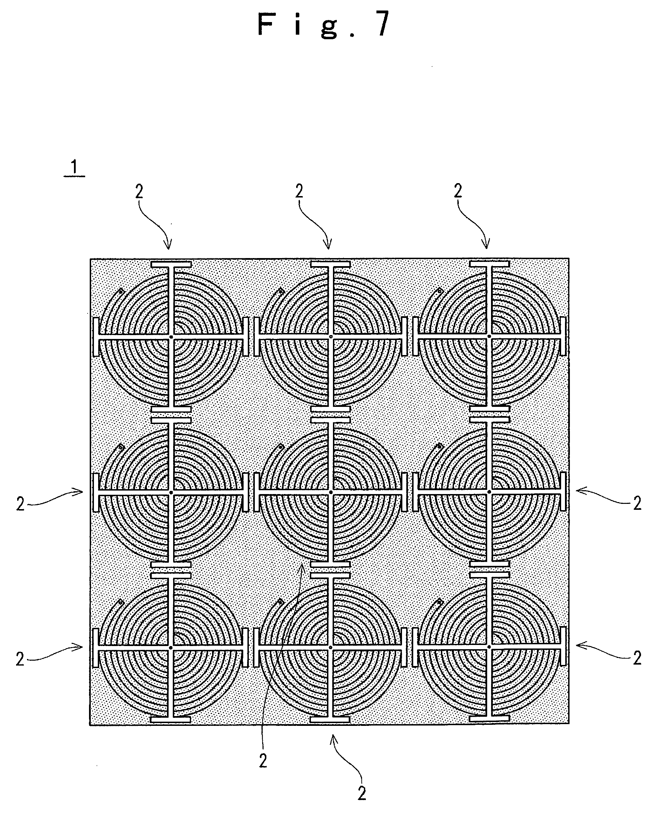

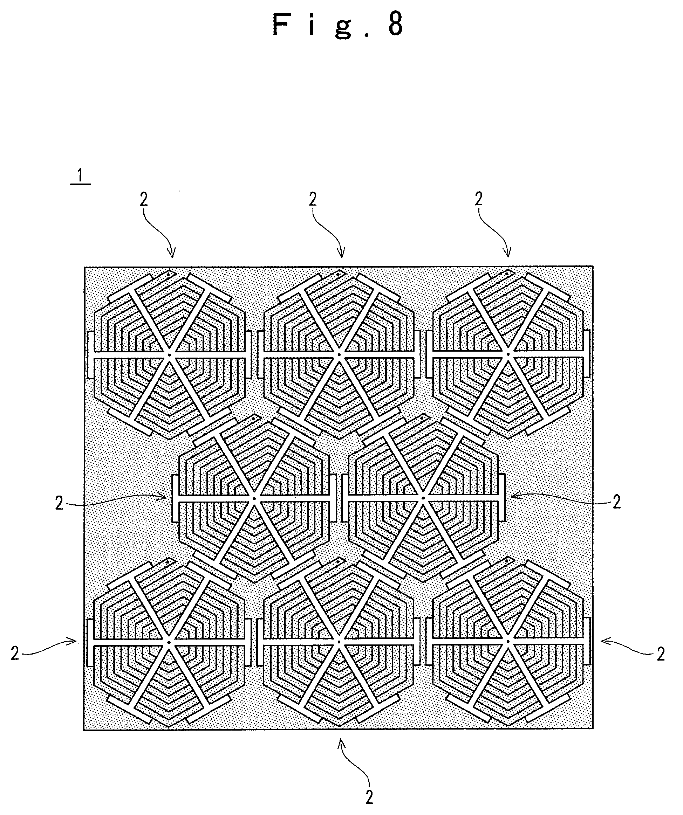

The EGB structure of the present invention is not necessarily limited to the above embodiments. For example, as shown in Fig. 6, it may be configured such that the side parts 73 of the second conductor pattern 7 are further longer in length so as to have a further greater capacitor component C. As shown in Fig. 7, the second conductor pattern 7 may have a rounded spiral shape. As shown in Fig. 8, the second conductor pattern 7 may have a polygonal shape other than the square shape (a triangular shape, a pentagonal shape, a hexagonal shape, an octagonal shape or the like, for example, the hexagonal shape in Fig. 8). In the configuration with the polygonal shape, the linear parts 72 and the side parts 73 of the second conductor pattern 7 are configured to correspond to the number of angles.

In the above embodiments, the capacitor is formed in a gap between the side parts of the adjacent second conductor patterns 7. However, the present invention is not necessarily limited thereto. A condenser may be provided in the path.

A plurality of the first conductor patterns 5 may be stacked on each other via inductor layers in order to obtain larger inductance component L. In this case, in order to prevent mutual elimination of their magnetic fields, the winding directions of the spirals are set to be opposite to each other between the adjacent first conductor patterns in the stacked direction. For example, in the case where three first conductor patterns 5 are stacked on each other (via inductor layers), the winding direction of the first conductor pattern 5 on the ground substrate 3 side is the same as the winding direction of the first conductor pattern 5 on the second conductor pattern 7 side, while the first conductor pattern 5 therebetween has a winding direction opposite thereto. Then, the outer ends 50 or the inner ends 51 of the first conductor patterns adjacent to each other in the stacked direction are electrically connected to each other (via a conductor pin).

In the side parts 73 of the adjacent second conductor patterns 7, a plurality of projections are formed with a distance from each other in a width direction, and these projections are disposed facing recesses of the side parts of the opposite member or disposed within the recesses. That is, an inter-digital structure is provided so as to be able to further increase the capacitor component C.

### INDUSTRIAL APPLICABILITY

The present invention is applicable to, for example, a grounding face for an antenna for wireless power transmission, to which band gap characteristics are required at a frequency band in MHz level or KHz level.

## Claims

1. An EBG structure comprising:
a ground substrate;
a dielectric layer that is disposed on the ground substrate; and
a conductor pattern that is disposed on the dielectric layer, and has one end and another end, the one end being electrically connected to the ground substrate.

2. An EBG structure comprising:
a ground substrate;
a first dielectric layer that is disposed on the ground substrate;
a first conductor pattern that is disposed on the first dielectric layer, and has an outer end and an inner end, the outer end being electrically connected to the ground substrate;
a second dielectric layer that is disposed on the first conductor pattern; and
a second conductor pattern that is disposed on the second dielectric layer, and has a center part and an outer end, the center part being electrically connected to the inner end of the first conductor pattern.

3. The EBG structure according to claim 2, wherein the first conductor pattern has a spiral shape.

4. The EBG structure according to claim 2 or 3, wherein the second conductor pattern has a linear part that extends radially from the center part, and a side part that crosses an end of the linear part and forms the outer end of the second conductor pattern.

5. The EBG structure according to claim 4, wherein the side part is disposed along the outer periphery of the first conductor pattern and is disposed outside the first conductor pattern.

6. The EBG structure according to claim 4 or 5, wherein a plurality of first conductor patterns are disposed in matrix like manner, and a plurality of second conductor patterns are disposed in matrix like manner so as to have the side parts of each adjacent second conductor patterns of the plurality of second conductor patterns facing each other.
